# EUROPEAN PATENT SPECIFICATION

(11) **EP 2 095 430 B1**
(45) Date of publication and mention of the grant of the patent: **20.11.2013**
(21) Application number: 07768670.7
(22) Date of filing: 10.07.2007
(51) Int. Cl.: H01L 31/042, H01L 31/0216, H01L 31/18

(54) **SOLAR CELL**
SOLARZELLE
CELLULE SOLAIRE

(30) Priority: 13.12.2006 KR 20060127389
(43) Date of publication of application: 02.09.2009
(73) Proprietor: LG Electronics Inc., Seoul 150-010 (KR)
(72) Inventor: PARK, Hyun-Jung, Seoul, 137-130 (KR); KIM, Sung-JIn, Seoul 139-232 (KR); KIM, Jin-Ho, Daejeon 302-120 (KR)
(74) Representative: Katérle, Axel
(86) International application number: PCT/KR2007/003332
(87) International publication number: WO 2008/072828

(56) References cited:
- EP-A2- 1 635 398
- JP-B- 6 091 268
- US-A- 4 900 369
- US-A- 5 279 682
- US-A- 5 907 766
- US-A1- 2004 081 747
- US-A1- 2006 130 891
- US-A1- 2006 197 096
- US-B1- 6 277 667
- US-B2- 6 746 709

## Description

### Technical Field

The present invention relates to a solar cell, and more particularly to a solar cell having an improved anti-reflection film structure to reduce reflectance against photons and increase FF, which give excellent photoelectric conversion efficiency.

### Background Art

Recently, as exhaustion of existing energy resources such as petroleum and coal is estimated, interests on alternative energies for substituting them are more increased. Among the alternative energies, a solar cell is particularly spotlighted since its energy resource is sufficient and it does not cause any environmental pollution. A solar cell is classified into a solar heat cell that generates a vapor required for rotating a turbine using a solar heat, and a solar light cell that converts photons into electric energy using the properties of a semiconductor. Generally, a solar cell calls the solar light cell (hereinafter, the term 'solar cell' is used).

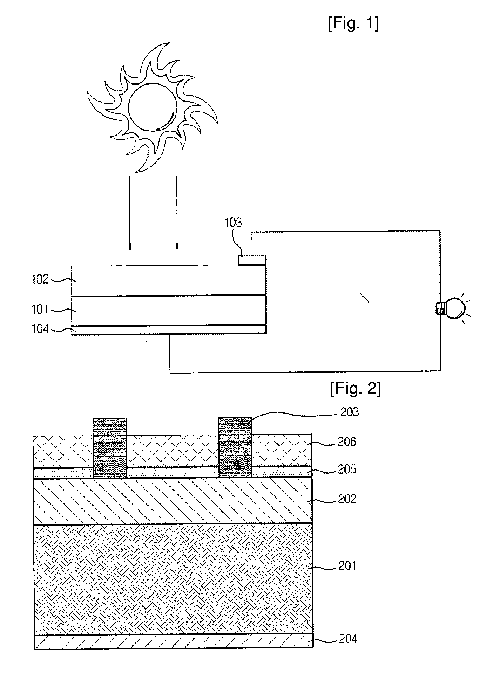

Referring to FIG. 1 showing a basic structure of a solar cell, the solar cell has a junction structure of a p-type semiconductor 101 and a n-type semiconductor 102 like a diode. If photons are input to the solar cell, the photons are reacted with materials of the semiconductor to generate electrons of (-) charge and holes of (+) charge caused by removal of the electrons, thereby allowing flow of electric current as they are moving. It is called photovoltaic effect. Among the p-type semiconductor 101 and the n-type semiconductor 102 that composes the solar cell, electrons are drawn toward the n-type semiconductor 102 and the holes are drawn toward the p-type semiconductor 101, so they are moved to electrodes 103, 104 joined to the n-type semiconductor 101 and the p-type semiconductor 102, respectively. If the electrodes 103, 104 are connected using a cable, it is possible to obtain an electric power as electricity flows.

Such output features of a solar cell are generally evaluated by measuring an output current-voltage curve using a solar simulator. On the curve, a point at which a multiplication Ip×Vp of an output current Ip and an output voltage Vp is maximum is called a maximum output Pm. Also, a value obtained by dividing Pm by a total optical energy (S×I: S is an area of an element, I is an intensity of light irradiated to the solar cell) input to the solar cell is defined as conversion efficiency η.

In order to enhance the efficiency η of a solar cell, it is required to increase a short-circuit current Jsc (an output current at V=0 on the current-voltage curve), an open voltage Voc (an output voltage at I=0 on the current-voltage curve), or FF (fill factor) indicating how the output current-voltage curve is close to a square shape. As FF has a value close to 1, the output current-voltage curve approximates to an ideal square shape, and the conversion efficiency η is increased. Mainly, Jsc is affected by absorption or reflectance against the light irradiated thereto, Voc is affected by the degree of recombination of carriers (electrons and holes), and FF is affected by a resistance in the n-type and p-type semiconductors and between the semiconductors.

Conventionally, as a scheme for enhancing efficiency of a solar cell, an anti-reflection film was used for reducing reflectance of light input to the solar cell, or an area hiding photons was minimized when forming an electrode terminal. Among them, various studies on the anti-reflection film capable of realizing a high reflectance are under progress. Recently, a method of forming a single anti-reflection film composed of a silicon nitride film on an emitter at a front surface of a solar cell to reduce reflectance was developed and widely used. As an example, Korean Laid-open Patent Publication No. 2003-0079265 discloses a double layer structure having single crystal silicon acting as a passivated layer and silicon nitride acting as an anti-reflection film. However, the single anti-reflection film structure composed of silicon nitride and the double anti-reflection film structure composed of single crystal silicon and silicon nitride may improve current characteristics by reducing reflectance of photons but show a problem that dopant of the anti-reflection film is moved toward a semiconductor layer and also there is no special increase of FF, so they have a limit in enhancing efficiency of a solar cell.

Meanwhile, US 6,518,200 discloses a method for forming a microelectronic layer in a micro structure, and it suggests that the microelectronic layer may be used in a photoelectron micro structure that composes a solar cell.

The microelectronic layer has a multi-layer laminate in a structure of silicon oxynitride layer / transition layer / silicon nitride layer / transition layer / silicon oxynitride layer. In addition, in aspect of composition of materials, based on the silicon nitride layer that is an intermediate layer, "lower layer + transition layer" and "transition layer + upper layer" are symmetric to each other. The transition layer is a material membrane interposed between the silicon oxynitride layer acting as the upper and lower layers and the silicon nitride layer acting as the intermediate layer. The transition layer is made of silicon oxynitride, and the concentration of oxygen atoms included in the material membrane is gradually lowered toward the silicon nitride layer acting as the intermediate layer, and the concentration of oxygen atoms becomes substantially zero at the silicon nitride layer acting as the intermediate layer.

Thus, the oxygen concentration of the microelectronic layer is continuously decreased from the silicon oxynitride layer acting as the upper and lower layers via the transition layer to the silicon nitride layer acting as the intermediate layer, and then the material membrane is converted into a silicon nitride layer at the intermediate layer with no oxygen atom.

However, US 6,518,200 does not disclose the usage of the microelectronic layer in the photoelectron micro structure of a solar cell in detail. However, the microelectronic layer may be used as an anti-reflection film in consideration of the structure of a solar cell.

But, the microelectronic layer of US 6,518,200 is a material membrane designed to relieve mechanical stress caused between different kinds of material membranes by continuously changing composition of multi material layers and setting the component ratio of material symmetrically based on the intermediate layer. Also, since the microelectronic layer has material composition symmetrical based on the intermediate layer and composition of the material membrane is continuously changed due to the presence of the transition layer, it is apparent to those having ordinary skill in the art that a refractive index profile of the microelectronic layer shows a greatest refractive index at the center and symmetric in a lateral direction like the normal distribution curve. It is because, considering the composition of material, the intermediate layer shows a relatively greater refractive index than the upper and lower layers, and the transition layer has a continuously changing oxygen concentration, which also makes the refractive index continuously changed. However, if the microelectronic layer has a refractive index profile as mentioned above, a proportion of photons reaching the p-n junction structure that gives the photovoltaic effect is rather decreased, thereby deteriorating the efficiency of a solar cell. It is because, if photons are input to the microelectronic layer, a part of photons are guided in plane through the intermediate layer with a relatively greater refractive index, so the proportion of photons reaching the p-n junction is decreased. Thus, the microelectronic layer of US 6,518,200 has a limit in being adopted as an anti-reflection film structure of a high efficient solar cell.
EP 1 635 398 A2 discloses a photovoltaic device comprising a passivated layer and an anti-reflection coating comprising silicon nitride.

### Disclosure of Invention

### Technical Problem

The present invention is designed to solve the problems of the prior art, and therefore it is an object of the present invention to improve an anti-reflection film structure of a solar cell, thereby providing a solar cell capable of reducing reflectance of the solar cell against light, preventing deterioration of properties caused by the anti-reflection film, and increasing FF to improve efficiency of the solar cell.

### Technical Solution

In order to accomplish the above object, the present invention provides a solar cell, which includes a p-n structure having a first conductive semiconductor substrate, a second conductive semiconductor layer formed on the first conductive semiconductor substrate and having a conduction opposite to the first conductive semiconductor substrate, and a p-n junction formed at an interface between the first conductive semiconductor substrate and the second conductive semiconductor layer; a passivated layer formed on the second conductive semiconductor layer and composed of silicon oxynitride with a refractive index of 1.45 to 1.70; an anti-reflection film formed on the passivated layer and composed of silicon nitride; a front electrode connected to the second conductive semiconductor layer with passing through a part of the passivated layer and the anti-reflection film and exposed outward; and a rear electrode formed at an opposite side to the front electrode with the first conductive semiconductor substrate being interposed therebetween so as to be connected to the first conductive semiconductor substrate.

In the solar cell of the present invention, the anti-reflection film has a refractive index of 1.9 to 2.3, the passivated layer preferably has a thickness of 10 to 50 nm, and the anti-reflection film has a thickness of 50 to 100 nm. In addition, the passivated layer and the anti-reflection film are preferably formed using PECVD (Plasma Enhanced Chemical Vapor Deposition). It is also preferred that the first conductive semiconductor substrate is a p-type silicon substrate and the second conductive semiconductor layer is a n-type emitter layer, and a p+ layer is preferably formed at an interface between the first conductive semiconductor substrate and the rear electrode.

### Brief Description of the Drawings

Other objects and aspects of the present invention will become apparent from the following description of embodiments with reference to the accompanying drawing in which:

FIG. 1 is a schematic view showing a basic structure of a solar cell;

FIG. 2 is a schematic view showing a solar cell according to one embodiment of the present invention; and

FIG. 3 is a graph showing measurement result of Dark I-V data for solar cells according to a first embodiment and a first comparative example.

### Best Mode for Carrying Out the Invention

Hereinafter, a preferred embodiment of the present invention will be explained with reference to the accompanying drawing.

FIG. 2 is a schematic view showing a solar cell according to one embodiment of the present invention. As shown in FIG. 2, the solar cell of the present invention includes a p-n structure, a passivated layer 205, an anti-reflection film 206, a front electrode 203 and a rear electrode 204.

The p-n structure includes a first conductive semiconductor substrate 201, a second conductive semiconductor layer 202 formed on the first conductive semiconductor substrate 201 and having an opposite conduction to the first conductive semiconductor substrate 201, and a p-n junction formed at an interface between the first conductive semiconductor substrate 201 and the second conductive semiconductor layer 202. The p-n structure receives light to generate current by means of photovoltaic effect. Representatively, the first conductive semiconductor substrate 201 is a p-type silicon substrate doped with Group 3 element such as B, Ga and In, and the second conductive semiconductor layer 202 is a n-type emitter layer doped with Group 5 element such as P, As and Sb. The p-n junction may be formed by joining the p-type silicon substrate and the n-type emitter layer. As an alternative, the p-n junction may also be formed by laminating a p-type emitter layer on a n-type silicon substrate. However, the p-n structure of the present invention is not limited thereto.

On the second conductive semiconductor layer 202 having the p-n structure, the passivated layer 205 composed of silicon oxynitride and the anti-reflection film 206 composed of silicon nitride are subsequently formed. That is to say, the passivated layer 205 is formed on the second conductive semiconductor layer 202, and the anti-reflection film 206 is formed on the passivated layer 205. The front electrode 203 formed on the passivated layer 205 and the anti-reflection film 206 is connected to a pa rt of the second conductive semiconductor layer 202 through a part of the passivated layer 205 and the anti-reflection film 206. Such structure of the passivated layer 205 and the anti-reflection film 206 minimizes reflectance of light irradiated to the solar cell and effectively prevents recombination of carriers on a semiconductor surface by means of the passivated layer, thereby capable of improving the photovoltaic efficiency. In addition, the passivated layer has an optimized refractive index to increase FF, thereby improving the photovoltaic efficiency. Such a refractive index of the passivated layer is 1.45 to 1.70. In relation to the numerical limit for the refractive index of the passivated layer 205, the lowest limit is a smallest refractive index that can be made using silicon oxynitride, and if the refractive index of the passivated layer exceeds the upper limit, the effect of increasing FF is eliminated since the features of silicon nitride become dominant.

The anti-reflection film 206 preferably has a refractive index of 1.9 to 2.3. In relation to the numerical limit for the anti-reflection film 206, the lowest limit is a smallest refractive index that can be made using silicon nitride, and if the refractive index of the anti-reflection film exceeds the upper limit, light absorbance of the silicon nitride anti-reflection film itself is increased, undesirably.

In addition, thicknesses of the passivated layer 205 and the anti-reflection film 206 are not specially limited. But, considering reflectance, the passivated layer 205 preferably has a thickness of 10 to 50 nm, and the anti-reflection film 206 preferably has a thickness of 50 to 100 nm. In relation to the numerical limit for the thickness of the passivated layer 205, a thickness of the passivated layer 205 less than the lower limit is not sufficient for the passivated layer 205 to give its function, and a thickness of the passivated layer 205 exceeding the upper limit is not desirable in aspect of reflectance. In relation to the numerical limit for the thickness of the anti-reflection film 206, a thickness of the anti-reflection film 206 less than the lower limit is not sufficient for the anti-reflection film 206 to give its function, and a thickness of the anti-reflection film 206 exceeding the upper limit makes the entire thickness of the anti-reflection film greater, which makes it difficult that the front electrode passes through the passivated layer and the anti-reflection film when being formed.

A method for forming the passivated layer 205 and the anti-reflection film 206 is not specially limited, but preferably adopts PECVD (Plasma Enhanced Chemical Vapor Deposition) to allow successive processes in-situ. The passivated layer and the anti-reflection film deposited by CVD have hydrogen atoms therein, which passivated defects on or in a silicon surface.

The front electrode 203 is formed to pass through a part of the passivated layer 205 and the anti-reflection film 206 and be connected to a part of the second conductive semiconductor layer 202. In addition, the rear electrode 204 is formed to be connected to the first conductive semiconductor substrate 201 at an opposite side to the front electrode 203 with the passivated layer 205, the anti-reflection film 206 and the first conductive semiconductor substrate 201 being interposed therebetween. If loads are applied to these electrodes 203, 204, electricity generated in the solar cell can be utilized. The front electrode 203 representatively employs a silver electrode since the silver electrode has an excellent electric conductivity. Also, the rear electrode 204 representatively employs an aluminum electrode since the aluminum electrode has an excellent conductivity and allows well junction due to good affinity with silicon. In addition, the aluminum electrode corresponds to Group 3 element, which forms a p+ layer, namely BSF (Back Surface Field), at a contact surface with the silicon substrate such that carriers are not disappeared but collected, thereby enhancing efficiency of the solar cell.

Hereinafter, a method for manufacturing a solar cell according to the present invention as explained above will be described as an example. This description is just for facilitating understanding of the present invention, not limiting the scope of the present invention.

First, on the first conductive semiconductor substrate 201, the second conductive semiconductor layer 202 having an opposite conduction thereto is formed such that a p-n junction is formed at their interface. A p-type silicon substrate is representatively used as the first conductive semiconductor substrate 201. For example, a p-type silicon substrate is coated with a n-type dopant and then thermally treated such that the n-type dopant is diffused to the p-type silicon substrate, thereby forming the p-n junction.

Then, the passivated layer 205 composed of silicon oxynitride is formed on the second conductive semiconductor layer 202. The passivated layer may be formed using CVD or PECVD as an example.

Then, the anti-reflection film 206 composed of silicon nitride film is formed on the passivated layer 205. The anti-reflection film may be formed using CVD or PECVD.

In case of using PECVD, a refractive index of silicon oxynitride may be controlled by changing relative flux ratios of SiH₄, NH₃ and N₂O gases. For example, in the same SiH₄ gas flux (15 sccm), in case a ratio of N₂O/NH₃ is 40, a refractive index becomes about 1.60, and in case a ratio of N₂O/NH₃ becomes 4, a refractive index is increased to about 1.68. Also, a refractive index of silicon nitride may be controlled by changing a relative flux ratio of SiH₄ and NH₃ gases. For example, in case a ratio of SiH₄/NH₃ is 0.3, a refractive index becomes about 1.90, and in case a ratio of SiH /NH becomes 4 3 1.2, a refractive index is increased to about 2.1. Thicknesses of silicon oxynitride thin film and silicon nitride thin film may be controlled by changing plasma power and deposition time.

Then, the front electrode 203 connected to the second conductive semiconductor layer 202 is formed on the anti-reflection film 206, and the rear electrode 204 is formed at an opposite side to the front electrode 203 with the first conductive semiconductor substrate 201 being interposed therebetween, so as to be connected to the first conductive semiconductor substrate 201. For example, the front electrode 203 and the rear electrode 204 may be formed by coating an electrode-forming paste according to a predetermined pattern and then thermally treating it. Due to the thermal treatment, the front electrode 203 punches through the passivated layer 205 and the anti-reflection film 206 and connects to the second conductive semiconductor layer 202, and BSF is formed in the rear electrode and the first conductive semiconductor substrate 201. The front electrode 203 and the rear electrode 204 may be formed in a reverse order, and also they may be formed by coating paste separately and then thermally treating at the same time.

Hereinafter, the present invention will be explained in more detail using an experimental example. However, it should be understood that the following examples may be modified in various ways, and the scope of the invention should not be limited to the following examples. The following examples are just for better understanding of the present invention to those having ordinary skill in the art.

Experimental Example 1

A solar cell having a structure including the passivated layer and the anti-reflection film as shown in FIG. 2 was prepared. At this time, a p-type silicon substrate (0.5 to 2 Ω) of Cz mono 125×125 cm² was used as a semiconductor substrate, and a n+ emitter layer was formed in 60 Ω/sheet. A passivated layer (refractive index: 1.55, thickness: 30 nm) composed of silicon oxynitride was formed on the emitter layer using Direct High Frequency (13.56 MHz) PECVD, and an anti-reflection film (refractive index: 1.90, thickness: 64 nm) composed of silicon nitride was formed on the passivated layer. Deposition temperature for the passivated layer and the anti-reflection film was 350°C. After that, a silver electrode pattern was printed on the anti-reflection film by means of screen printing, an aluminum electrode was printed on a side of the semi-conductor substrate opposite to the surface where the emitter layer was formed, by means of screen printing, and then they were thermally treated for 30 seconds at 800°C to form a front electrode and a rear electrode.

Experimental Example 2

A solar cell having a structure including the passivated layer and the anti-reflection film as shown in FIG. 2 was prepared. At this time, a p-type silicon substrate (0.5 to 2 Ω) of Cz mono 125×125 cm² was used as a semiconductor substrate, and a n+ emitter layer was formed in 60 Ω/sheet. A passivated layer (refractive index: 1.65, thickness: 25 nm) composed of silicon oxynitride was formed on the emitter layer using Direct High Frequency (13.56 MHz) PECVD, and an anti-reflection film (refractive index: 1.90, thickness: 64 nm) composed of silicon nitride was formed on the passivated layer. Deposition temperature for the passivated layer and the anti-reflection film was 350°C. After that, a silver electrode pattern was printed on the anti-reflection film by means of screen printing, an aluminum electrode was printed on a side of the semiconductor substrate opposite to the surface where the emitter layer was formed, by means of screen printing, and then they were thermally treated for 30 seconds at 800°C to form a front electrode and a rear electrode.

Comparative Example 1

A solar cell having a single anti-reflection film structure composed of silicon nitride was prepared. At this time, a p-type silicon substrate (0.5 to 2 Ω) of Cz mono 125x 125 cm² was used as a semiconductor substrate, and a n+ emitter layer was formed in 60 Ω/ sheet. An anti-reflection film (refractive index: 2.10, thickness: 75 nm) composed of silicon nitride was formed on the emitter layer using Direct High Frequency (13.56 MHz) PECVD. Deposition temperature for the anti-reflection film was 350°C. After that, a silver electrode pattern was printed on the anti-reflection film by means of screen printing, an aluminum electrode was printed on a side of the semiconductor substrate opposite to the surface where the emitter layer was formed, by means of screen printing, and then they were thermally treated for 30 seconds at 800°C to form a front electrode and a rear electrode.

**Measurement of Dark I-V Data**

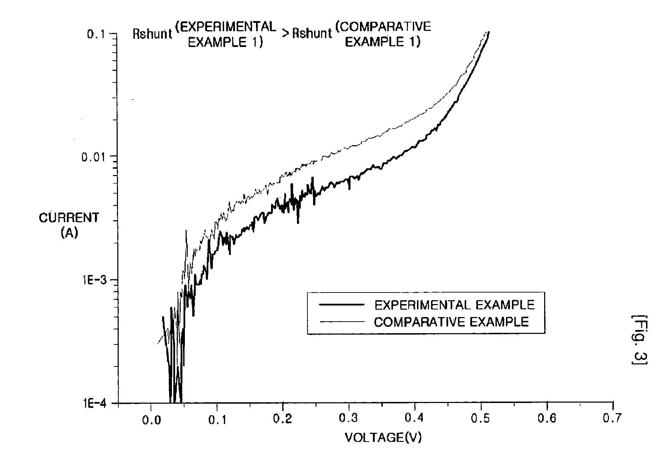

Measurement results of Dark I-V data for the solar cells prepared according to the experimental example 1 and the comparative example 1 are shown in a graph of FIG. 3. The Dark I-V data of a solar cell shows electric features of a p-n diode itself as voltage is applied while no light is irradiated to the solar cell. For example, the Dark I-V data allows analogizing junction leakage current, shunt resistance, diode ideality factor, and so on. In the graph of FIG. 3, by comparing current values in a low voltage range (0 to 0.3V), it would be understood that the solar cell of the experimental example 1 with a double structure having a passivated layer and an anti-reflection layer shows a smaller current in comparison to the solar cell of the comparative example 1. From this, it would be understood that the solar cell of the experimental example 1 has a greater shunt resistance than the solar cell of the comparative example 1, and thus current formed in the solar cell does not disappear therein but flows through the front and rear electrodes, thereby increasing FF.

**Measurement for Photovoltaic Efficiency**

A solar simulator was used to measure short-circuit current Jsc, open voltage Voc, FF (Fill Factor) and photovoltaic efficiency of each solar cell prepared by the experimental examples 1 and 2 and the comparative example 1. The measurement results are listed in the following table 1. From the measurement results of the table 1, it would be found that the solar cells of the experimental examples 1 and 2 show open voltage and short-circuit current substantially similar to those of the solar cell of the comparative example 1, but FF is increased due to the increase of shunt resistance. Since the open voltage and the short-circuit current are kept similarly, it would be understood that there is caused no deterioration in other properties by adopting the double layer structure of the present invention.

**Table 1**

| | Short-circuit Current (mA) | Open Voltage (V) | FF (%) | Photovoltaic Efficiency (%) |
|---|---|---|---|---|
| Experimental Example 1 | 32.7 | 0.620 | 79.0 | 16.0 |
| Experimental Example 2 | 32.2 | 0.616 | 79.0 | 15.7 |
| Comparative Example 1 | 32.4 | 0.618 | 78.4 | 15.7 |

It should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation.

Therefore, the description proposed herein is just a preferable example for the purpose of illustrations only, not intended to limit the scope of the invention, so it should be understood that other equivalents and modifications could be made thereto without departing from the spirit and scope of the invention.

### Industrial Applicability

The solar cell of the present invention includes a double layer structure in which a passivated layer made of silicon oxynitride and an anti-reflection film made of silicon nitride are subsequently laminated, so the solar cell shows reduced reflectance against light and increased FF with no deterioration of other properties, thereby giving improved photovoltaic efficiency. Also, the silicon oxynitride layer and the silicon nitride layer may be produced successively in situ and thus allow reduction of production costs.

## Claims

1. A solar cell comprising:
a p-n structure having a first conductive semiconductor substrate (201), a second conductive semiconductor layer (202) formed on the first conductive semiconductor substrate (201) and having a conduction opposite to the first conductive semiconductor substrate (201), and a p-n junction formed at an interface between the first conductive semiconductor substrate (201) and the second conductive semiconductor layer (202);
a passivated layer (205) formed on the second conductive semiconductor layer (202) and composed of silicon oxynitride;
an anti-reflection film (206) formed on the passivated layer (205) and composed of silicon nitride;
a front electrode (203) connected to the second conductive semiconductor layer (202) with passing through a part of the passivated layer (205) and the anti-reflection film (206) and exposed outward; and
a rear electrode (204) formed at an opposite side to the front electrode (203) with the first conductive semiconductor substrate (201) being interposed therebetween so as to be connected to the first conductive semiconductor substrate (201),
**characterized in that**
said passivated layer (205) has a refractive index of 1.45 to1.70, and
said anti-reflection film (206) has a refractive index of 1.9 to 2.3 and said anti-reflection film (206) has a thickness of 50 to 100 nm.

2. The solar cell according to claim 1, wherein the passivated layer (205) has a thickness of 10 to 50 nm.

3. The solar cell according to claim 1, wherein the passivated layer (205) is formed using PECVD (Plasma Enhanced Chemical Vapor Deposition).

4. The solar cell according to claim 1, wherein the anti-reflection film (206) is formed using PECVD.

5. The solar cell according to claim 1, wherein the first conductive semiconductor substrate (201) is a p-type silicon substrate, and the second conductive semiconductor layer (202) is a n-type emitter layer.

6. The solar cell according to claim 1, wherein a p+ layer is formed at an interface between the first conductive semiconductor substrate (201) and the rear electrode (204).

## Patentansprüche

1. Solarzelle, die umfasst:
- eine p-n-Struktur mit einem ersten leitfähigen Halbleitersubstrat (201), einer zweiten leitfähigen Halbleiterschicht (202), die auf dem ersten leitfähigen Halbleitersubstrat (201) gebildet ist und eine zum ersten leitfähigen Halbleitersubstrat (201) entgegengesetzte Leitfähigkeit hat, und einem p-n-Übergang, der an einer Grenzfläche zwischen dem ersten leitfähigen Halbleitersubstrat (201) und der zweiten leitfähigen Halbleiterschicht (202) gebildet ist,
- eine passivierte Schicht (205), die auf der zweiten leitfähigen Halbleiterschicht (202) gebildet ist und aus Siliziumoxynitrid besteht,
- einen Antireflexionsfilm (206), der auf der passivierten Schicht (205) gebildet ist und aus Siliziumnitrid besteht,
- eine vordere Elektrode (203), die mit der zweiten leitfähigen Halbleiterschicht (202) verbunden ist, durch einen Teil der passivierten Schicht (205) und des Antireflexionsfilms (206) hindurchragt und nach außen freiliegt, und
- eine rückwärtige Elektrode (204), die auf einer der vorderen Elektrode (203) entgegengesetzten Seite gebildet ist, wobei das erste leitfähige Halbleitersubstrat (201) dazwischen angeordnet ist, so dass sie mit dem ersten leitfähigen Halbleitersubstrat (201) verbunden ist,
**dadurch gekennzeichnet, dass**
- die passivierte Schicht (205) einen Brechungsindex von 1,45 bis 1,70 hat, und
- der Antireflexionsfilm (206) einen Brechungsindex von 1,9 bis 2,3 hat und der Antireflexionsfilm (206) eine Dicke von 50 bis 100 nm aufweist.

2. Solarzelle nach Anspruch 1, wobei die passivierte Schicht (205) eine Dicke von 10 bis 50 nm aufweist.

3. Solarzelle nach Anspruch 1, wobei die passivierte Schicht (205) unter Verwendung von PECVD (plasmaunterstützte chemische Dampfabscheidung) gebildet ist.

4. Solarzelle nach Anspruch 1, wobei der Antireflexionsfilm (206) unter Verwendung von PECVD gebildet ist.

5. Solarzelle nach Anspruch 1, wobei das erste leitfähige Halbleitersubstrat (201) ein p-Typ-Siliziumsubstrat ist und die zweite leitfähige Halbleiterschicht (202) eine n-Typ-Emitterschicht ist.

6. Solarzelle nach Anspruch 1, wobei an einer Grenzfläche zwischen dem ersten leitfähigen Halbleitersubstrat (201) und der rückwärtigen Elektrode (204) eine p+-Schicht gebildet ist.

## Revendications

1. Cellule photovoltaïque comprenant :
une structure p-n ayant un premier substrat (201) semi-conducteur conducteur, une deuxième couche (202) semi-conductrice conductrice formée sur le premier substrat (201) semi-conducteur conducteur et ayant une conduction opposée au premier substrat (201) semi-conducteur conducteur, et une jonction p-n formée au niveau d'une interface entre le premier substrat (201) semi-conducteur conducteur et la deuxième couche (202) semi-conductrice conductrice ;
une couche passivée (205) formée sur la deuxième couche (202) semi-conductrice conductrice et composée d'oxynitrure de silicium ;
un film antireflets (206) formé sur la couche passivée (205) et composé de nitrure de silicium ;
une électrode avant (203) connectée à la deuxième couche (202) semi-conductrice conductrice en passant à travers une partie de la couche passivée (205) et du film antireflets (206) et exposée vers l'extérieur ; et
une électrode arrière (204) formée sur un côté opposé de l'électrode avant (203) avec le premier substrat (201) semi-conducteur conducteur étant interposé entre celles-ci de façon à ce qu'elle soit connectée au premier substrat (201) semi-conducteur conducteur,
**caractérisée en ce que**
ladite couche passivée (205) a un indice de réfraction de 1,45 à 1,70, et
ledit film antireflets (206) a un indice de réfraction de 1,9 à 2,3 et ledit film antireflets (206) a une épaisseur de 50 à 100 nm.

2. Cellule photovoltaïque selon la revendication 1, dans laquelle la couche passivée (205) a une épaisseur de 10 à 50 nm.

3. Cellule photovoltaïque selon la revendication 1, dans laquelle la couche passivée (205) est formée en utilisant un PECVD (dépôt chimique en phase vapeur assisté par plasma).

4. Cellule photovoltaïque selon la revendication 1, dans laquelle le film antireflets (206) est formé en utilisant un PECVD.

5. Cellule photovoltaïque selon la revendication 1, dans laquelle le premier substrat (201) semi-conducteur conducteur est un substrat de silicium de type p, et la deuxième couche (202) semi-conductrice conductrice est une couche émettrice de type n.

6. Cellule photovoltaïque selon la revendication 1, dans laquelle une couche p+ est formée au niveau d'une interface entre le premier substrat (201) semi-conducteur conducteur et l'électrode arrière (204).
